# EUROPÄISCHE PATENTSCHRIFT

(11) **EP 0 341 751 B1**
(45) Veröffentlichungstag und Bekanntmachung des Hinweises auf die Patenterteilung: **01.09.1993**
(21) Anmeldenummer: 89108695.1
(22) Anmeldetag: 13.05.1989
(51) Int. Cl.: H05K 7/14, H05K 5/00

(54) **Regelgerät für Regelsysteme**
Control unit for control systems
Appareil de régulation pour système de régulation

(30) Priorität: 13.05.1988 DE 8806294 U
(43) Veröffentlichungstag der Anmeldung: 15.11.1989
(73) Patentinhaber: Viessmann Werke GmbH & Co, 35108 Allendorf (DE)
(72) Erfinder: Viessmann, Hans Dr., D-3559 Battenberg/Eder (DE)
(74) Vertreter: Wolf, Günter, Dipl.-Ing.

(56) Entgegenhaltungen:
- DE-U- 7 146 259
- DE-U- 8 429 699
- DE-U- 8 708 646
- US-A- 4 168 870

## Beschreibung

DieErfindung betrifft ein Regelgerät für Reglersysteme, insbesondere von Heizungsanlagen gemäß Oberbegriff des Hauptanspruches.

Regelgeräte der genannten Art sind allgemein bekannt und in Benutzung und bedürfen insoweit keines druckschriftlichen Nachweises, da diese Geräte in der Regel aus einem die Schaltkreise und die elektrischen bzw. elektronischen Elemente in Form von blockartigen Regel-und Steuerbausteinen aufnehmenden Gehäuse bestehen, in dessen Frontfläche die Einstell- und Anzeigeelemente angeordnet sind. Bei den Einstellelementen kann es sich dabei um druck- und/oder dreh- und/oder schieberbetätigbare Einstellelemente handeln. Zu einem Reglersystem dieser Art für eine Heizungsanlage gehören außer dem eigentlichen Regelgerät normalerweise auch mindestens eine Bedienungs- und Anzeigeeinheit, die auch als Fernbedienungsteil, als solches in einer Heizungsregelung oder bspw. auch an einem Mischermotor als Regelorgan zum Einsatz kommen kann.

Durch die Vielfalt der Regel- und Steueraufgaben und der Anzeige- und Einstellelemente derartiger zentraler Regelgeräte ergibt sich zumindest für den Nichtfachmann eine verwirrende Fülle von betätigbaren Elementen und Anzeigefeldern, mit denen dieser in der Regel nichts oder nur wenig anzufangen weiß, wobei es aber auch für den bewanderten Heizungstechniker vorteilhafter wäre, wenn sich diese Vielfalt von Elementen in übersichtlicher und in nach Aufgaben gegliederter Ordnung dem Benutzer darbieten würden. Einer solchen Ordnung sind aber allein schon durch die Größe der Gehäuse bzw. der dafür verfügbaren Frontfläche Grenzen gesetzt.

Der Erfindung liegt demgemäß die Aufgabe zugrunde, ein Gerät der gattungsgemäßen Art dahingehend zu verbessern, daß für insbesondere den fachunkundigen Benutzern von mit derartigen Geräten ausgestatteter Heizungsanlagen die Vielfalt der erwähnten Anzeige- und Stellelemente sichtseitig auf ein Minimum, d.h., auf ein Betriebs- und Störfallanzeigeelement reduziert werden kann und zwar mit der Maßgabe, daß die Stellelemente und die spezifischen Anzeigeelemente trotzdem problemlos zugriffsbereit am Gerätegehäuse untergebracht sein sollen.

Diese Aufgabe ist mit einem Regelgerät der eingangs genannten Art nach der Erfindung durch die im Kennzeichen des Hauptanspruches angeführten Merkmale gelöst. Vorteilhafte Weiterbildungen und praktische Ausführungsformen ergeben sich nach den Unteransprüchen.

Durch diese neuartige Ausbildung sind bis auf das am Verschlußdeckel der Frontfläche sichtseitig angeordnete Betriebs- und Störfallanzeigeelement alle anderen Elemente zunächst der unmittelbaren Sicht entzogen, so daß der nicht fachkundige, aber natürlich auch der fachkundige Gerätebetrachter zunächst nur die Information erhält, ob das Regelgerät und damit die von diesem geregelte und gesteuerte Heizungsanlage einwandfrei arbeitet oder nicht.

Klapp- bzw. Abdeckverschlüsse an Frontflächen derartiger Geräte sind zwar bekannt, aber solche Verschlüsse decken immer nur einen kleinen Teilbereich der Frontfläche ab und außerdem weisen diese Verschlüsse sichtseitig keine Betriebs- oder Störfallanzeigeelemente auf. Soweit die Frontfläche ganzflächig abdeckende Verschlußdeckel bekannt sind, sind diese aus transparentem Material gefertigt und zwar um die Frontfläche mit ih rer Vielzahl von Informations- und Stellelementen für eine unbehinderte Sicht zugänglich zu halten (siehe z. B. DE-U-7146259). Im Gegensatz dazu repräsentiert sich das neuartige Regelgehäuse in Schließstellung des Verschlußdeckels als praktisch äußerlich glatter Kasten, an dem lediglich das Betriebs- und Störfallanzeigeelement markant ins Auge fällt.

Die neuartige Lösung hat außerdem den Vorteil, daß durch den opak gehaltenen Verschlußdeckel, der für die Bedienung des Gerätes einfach in eine die eigentliche Frontfläche freigebende Stellung gebracht wird (bevorzugt wird der Verschlußdeckel einfach hochgeschwenkt) am Gerät eine zusätzlich verfügbare Fläche geschaffen ist, die, was noch näher erläutert wird, für eine übersichtlichere Anordnung von "Gerätebausteinen" zur Verfügung steht, die blockartig im Gehäuse und im Verschlußdeckel eingesetzt sind. Obgleich der Verschlußdeckel, die Verschlußklappe und auch die Abdeckklappe bezüglich ihrer Verstellbarkeit zum Gehäuse bzw. untereinander bspw. auch als Schieber ausgebildet und ggf. auch nach jeder gewünschten und geeignet verfügbaren Freiseite des Gehäuses verstellbar angeordnet sein können, werden diese Verschlüsse, da am einfachsten zu verwirklichen, bevorzugt als schwenkbare Verschlüsse ausgebildet und angeordnet, wobei der Verschlußdeckel der Frontfläche nach oben, die am Verschlußdeckel angelenkte Verschlußklappe und ebenfalls die Frontflächen-Abdeckklappe nach unten verschwenkbar angeordnet sind. Durch diese neuartige Verschlußgliederung, die in ihrer bevorzugten Ausführungsform außerdem zusätzlichen Raum für die Unterbringung von Gerätebausteinen schafft, können die Bedienungs- und Anzeigeelemente sehr übersichtlich und gegliedert angeordnet und gewissermaßen stufenweise bei entsprechender Aufschwenkung der Deckel bzw. Klappen für einen Sicht- bzw. Betätigungszugriff freigestellt werden. Die Deckel bzw. Klappen sind dabei zweckmäßig durch geeignete Fixierungselemente so ausgebildet, daß sie in ihren eingenommenen öffnungs- bzw. Schließstellungen verbleiben.

Bezüglich der Dimensionierung des Verschlußdeckels ist dabei darauf hinzuweisen, daß der Verschlußdeckel auch so tief bemessen werden kann, daß sich insofern praktisch ein zweiteiliges Gehäuse ergibt, von dem die vordere Hälfte, also das Verschlußdeckelteil hochgeklappt und auf die andere Hälfte des Gehäuseteils aufgesetzt werden kann, die in geeigneter Weise auf einer Tragfläche befestigt ist, bei der es sich in der Regel um die Außenverkleidung eines Heizkessels handeln wird.

Das neuartige Regelgerät wird nachfolgend anhand der zeichnerischen Darstellung von Ausführungsbeispielen näher erläutert.

Es zeigt schematisch
- Fig. 1: in Seitenansicht das Regelgerät mit dem Verschlußdeckel in Schließstellung;
- Fig. 2: in Seitenansicht das Regelgerät mit allen Verschlußdeckeln bzw. Verschlußklappen in öffnungsstellung;
- Fig. 3: perspektivisch den kastenförmig ausgebildeten Verschlußdeckel;
- Fig. 4: eine Frontansicht des Gerätes im geschlossenen Zustand;
- Fig. 5: das Gerät in Frontansicht bei geöffnetem Verschlußdeckel und
- Fig. 6: das Gerät in Frontansicht, bei dem alle Deckel bzw. Klappen gemäß Fig. 2 geöffnet sind.

Das Regelgerät besteht aus einem Gehäuse 5 mit in der Frontfläche 1 des Gehäuses 5 angeordneten Anzeigeelementen 11 und Einstellelementen 12. Die im Gehäuse 5 und im Verschlußdeckel 2 angeordneten und blockartigen Regel- und Steuereinheiten 8 sind als "Gerätebausteine" mit 13 bezeichnet.

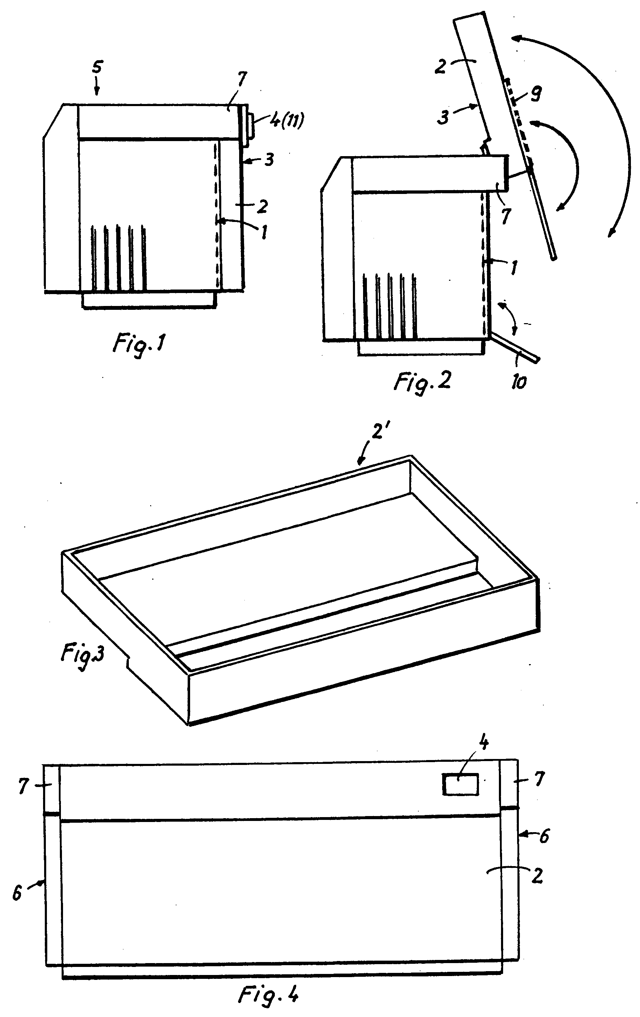

Wie aus Fig. 1, 2 ersichtlich, ist die Frontfläche 1 des Gehäuses mit einem nach oben aufschwenkbaren, alle Anzeige- und Einstellelemente 11, 12 abdeckenden, opaken Verschlußdeckel 2 versehen, der auf seiner äußeren Sichtfläche 3 lediglich mit einem Betriebs- und/oder Störfallanzeigeelement 4 ausgestattet ist. Für die Anlenkung des Verschlußdeckels sind an den Seitenflanken 6 (siehe Fig. 4) Gelenkvorsprünge 7 angeordnet, an denen der Verschlußdeckel 2 in geeigneter Weise schwenkbar gelagert ist. Der Schwenkbereich des Verschlußdeckels 2 ist dabei so bemessen, daß dieser in öffnungsstellung (wie aus Fig. 2 ersichtlich) in bezug auf das Gehäuse 5 bzw. die gestrichelt angedeutete Frontfläche 1 eine Schrägstellung einnimmt, so daß sich die Innenseite des Verschlußdeckels 2 gewissermaßen pultartig dem Betrachtet darbietet. Der aus opakem Material gebildete Verschlußdeckel 2 ist vorteilhaft und wie aus Fig. 3 ersichtlich, in Form eines gegen die Frontfläche 1 des Gehäuses flacher, offener Kasten 2' ausgebildet, so daß in diesen "Gerätebausteine", angepaßt an die Kastenform des Verschlußdeckels 2, eingesetzt bzw. eingebaut werden können. Bei diesen "Gerätebausteinen" handelt es sich bevorzugt um die sogenannten Bedienungseinheiten, während im Gehäuse 5 selbst, ebenfalls blockartig und formangepaßt die eigentlichen Regel- und Steuerbausteine 13 angeordnet sind.

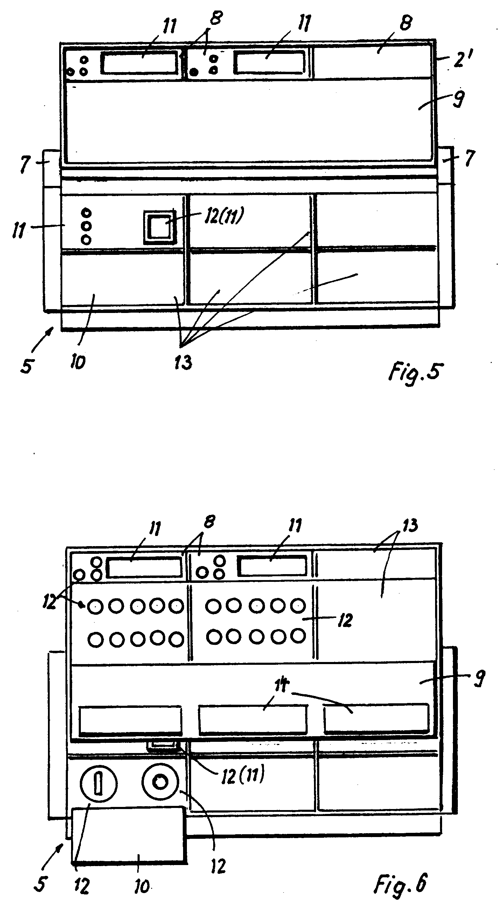

Die im Verschlußdeckel 2 angeordneten Baueinheiten sind zum Teil, wie aus Fig. 5 ersichtlich, ebenfalls mit einer Verschlußklappe 9 abgedeckt, die selbst am Verschlußdeckel 2 nach unten aufklappbar angelenkt ist. Bei aufgeklapptem Verschlußdeckel 2 in die Stellung gemäß Fig. 2, 5, sind dadurch ebenfalls zunächst nur die Anzeigeelemente 11 der Sicht und ggf. einige wenige Betätigungselemente einem Zugriff zugänglich und außerdem ist die Frontfläche 1 des Gehäuses 5 freigestellt, bei den durch diese Weise zugänglich gemachten Betätigungselementen im Verschlußdeckel 2 bzw. 2' handelt es sich dabei zweckmäßig um solche, die auch vom nicht fachkundigen Benutzer betätigt werden können. Erst wenn die Verschlußklappe 9 im Verschlußdeckel 2, wie aus Fig. 2, 5 ersichtlich, nach unten aufgeklappt wird, wird die Vielzahl von Betätigungselementen 12 zugänglich, die dann vom fachkundigen Benutzer, der mit den Regel- und Steueraufgaben eines solchen Gerätes besser vertraut ist, betätigt werden können. Bei geschlossener Verschlußklappe 9 kann auf der Sichtseite dieser Klappe 9 ein entsprechender Vermerk angebracht sein, daß die darunter befindlichen Betätigungselemente einer fachkundigen Bedienung bedürfen. Die innere Fläche dieser Verschlußklappe 9 bietet dabei vorteilhaft ausreichend Raum, um betätigungsspezifische Schriftfelder 14 unterbringen zu können.

Vorteilhaft kann ferner, wie aus den Fig. 5, 6 ersichtlich, auch die Frontfläche 1 des Gerätegehäuses 5 teilweise ebenfalls mit Abdeckklappen 10 versehen sein, die zunächst wiederum spezifische Einstellelemente 12 abdecken, die erst nach öffnung der Klappe 10 einem Zugriff zugänglich sind.

## Patentansprüche

1. Regelgerät für Reglersysteme, insbesondere für Heizungsanlagen, bestehend aus einem Gehäuse mit in der Gehäusefrontfläche angeordneten Anzeigeelementen und druck- und/oder dreh- und/oder schiebebetätigbaren Einstellelementen von im Gehäuse angeordneten blockartigen Regel- und Steuerbausteinen,
**dadurch gekennzeichnet,**
daß die Frontfläche (1) mit einem in bezug auf das Gehäuse nach oben, unten oder seitlich aufschwenk- oder aufschiebbaren, alle Anzeige- und Einstellelemente abdeckenden, opaken Verschlußdeckel (2) versehen und dieser auf seiner äußeren Sichtfläche (3) mit einem Betriebs- und/oder Störfallanzeigeelement (4) ausgestattet ist.

2. Gerät nach Anspruch 1,
**dadurch gekennzeichnet,**
daß der Verschlußdeckel (2) in Form eines gegen die Frontfläche (1) des Gehäuses (5) flachen, offenen Kastens(2') ausgebildet und in diesem mindestens einer der Regel- und Steuerbauteile, angepaßt an die Kastenform des Verschlußdeckels (2), angeordnet ist.

3. Gerät nach Anspruch 1 oder 2,
**dadurch gekennzeichnet,**
daß an den Seitenflanken (6) des Gehäuses (5), die Frontfläche (1) überragend, Gelenk- oder Führungsvorsprünge (7) angeordnet sind, an denen der Verschlußdeckel (2) schwenk- oder verschiebbar gelagert ist.

4. Gerät nach Anspruch 2 oder 3,
**dadurch gekennzeichnet,**
daß die im Verschlußdeckel (2) angeordneten Regel-und Steuerbausteine (8) mindestens zum Teil mit einer Verschlußklappe (9) abgedeckt sind, die am Verschlußdeckel (2) nach oben, unten oder seitlich aufschwenk- oder aufschiebbar angeordnet ist.

5. Gerät nach einem der Ansprüche 1 bis 4,
**dadurch gekennzeichnet,**
daß die Frontfläche (1) des Gehäuses (5) ganz oder teilweise ebenfalls mit mindestens einer Abdeckklappe (10) versehen ist.

6. Gerät nach einem der Ansprüche 2 bis 5,
**dadurch gekennzeichnet,**
daß der Verschlußdeckel (2) in bezug auf die Gehäusefrontfläche (1) nach oben, die mindestens eine Verschlußklappe (9) am Verschlußdeckel (2) nach unten verstellbar angeordnet ist.

7. Gerät nach Anspruch 5 oder 6,
**dadurch gekennzeichnet,**
daß die mindestens eine Abdeckklappe (10) der Frontfläche (1) nach unten verstellbar angeordnet ist.

8. Gerät nach einem der Ansprüche 1 bis 7,
**dadurch gekennzeichnet,**
daß der Verschlußdeckel (2) in öffnungsstellung und in bezug auf die Ebene der Frontfläche (1) zum Gehäuse (5) hin in Schrägstellung angeordnet ist.

## Claims

1. A regulator for control assemblies, in particular, of heating systems, comprising a casing furnished with display elements disposed in the front face of the casing and with pressure- and/or rotation- and/or slide-actuable adjusting elements of block-type regulating and control units disposed in the casing,
characterized in that the front surface (1) is provided with an opaque closure lid (2) which relative to the casing is swivable or slidable towards the top, the bottom or the side, masking all display and adjusting elements, and that the said closure lid (2), on the outer sight surface (3) thereof, is furnished with an operating and/or failure indicating element (4).

2. A regulator according to claim 1,
characterized in that the closure lid (2) is configured as a box (2') flat and open towards the front surface (1) of the casing (5), and that disposed therein, in a manner conforming to the box shape of the closure lid (2), is at least one of the regulating and control units.

3. A regulator according to claims 1 or 2,
characterized in that disposed, in a manner protruding beyond the front surface (1), on the side flanks (6) of the casing (5), are articulated or guiding projections (7) on which the closure lid (2) is swivably or displaceably disposed.

4. A regulator according to claims 2 or 3,
characterized in that the regulating and control units (8) disposed within the closure lid (2) at least in part are masked by a closure flap (9) disposed on the closure lid (2) in a manner swivable or sidable towards the top, bottom or side.

5. A regulator according to any one of claims 1 to 4,
characterized in that the front surface (1) of the casing (5), in whole or in part, equally is provided with at least one masking flap (10).

6. A regulator according to any one of claims 2 to 5,
characterized in that the closure lid (2), relative to the front surface (1) of the casing, is disposed in a manner adjustable to the top, while the at least one closure flap (9), on the closure lid (2), is disposed in a manner adjustable to the bottom.

7. A regulator according to claims 5 or 6,
characterized in that the at least one masking flap (10) of the front surface (1) is disposed in a manner adjustable to the bottom.

8. A regulator according to claims 1 to 7,
characterized in that the closure lid (2), in the opening position and relative to the plane of the front surface (1), is obliquely disposed towards the casing (5).

## Revendications

1. Régulateur pour systèmes de régulation, en particulier pour installations de chauffage, comprenant un boîtier munis d'éléments de visualisation et d'éléments de réglage qui peuvent être manoeuvrés par pression et/ou rotation et/ou coulissement, qui sont implantés dans la façade du boîtier et qui correspondent à des modules de régulation et de commande conçus sous forme de blocs et montés dans le boîtier, caractérisé en ce que la façade (1) est munie d'un couvercle de fermeture opaque (2) qui peut basculer ou coulisser en position ouverte vers le haut, vers le bas ou latéralement par rapport au boîtier et qui recouvre tous les éléments de visualisation et de réglage, et en ce que ledit couvercle de fermeture (2) est équipé, sur sa face apparente extérieure (3), d'un élément (4) de visualisation de fonctionnement et/ou de pannes.

2. Régulateur selon la revendication 1, caractérisé en ce que le couvercle de fermeture (2) est conçu sous la forme d'un caisson plat (2') ouvert en direction de la façade (1) du boîtier (5) et en ce que au moins un des organes de régulation et de commande, adapté à la forme en caisson du couvercle de fermeture (2), est monté dans ce dernier.

3. Régulateur selon la revendication 1 ou 2, caractérisé en ce que, sur les faces latérales (6) du boîtier (5), sont montées des saillies d'articulation ou de guidage (7) qui dépassent de la façade (1) et sur lesquelles le couvercle de fermeture (2) est monté de manière basculante ou coulissante.

4. Appareil selon la revendication 2 ou 3, caractérisé en ce que les modules de régulation et de commande (8) implantés dans le couvercle de fermeture (2) sont recouverts, au moins en partie, d'un volet de fermeture (9) qui est monté sur le couvercle de fermeture (2) de manière à basculer ou à coulisser en position ouverte vers le haut, vers le bas ou latéralement.

5. Régulateur selon l'une des revendications 1 à 4, caractérisé en ce que la façade (1) du boîtier (5) est également munie, en totalité ou en partie, d'au moins un volet de recouvrement (10).

6. Régulateur selon l'une des revendications 2 à 5, caractérisé en ce que le couvercle de fermeture (2) peut se déplacer vers le haut par rapport à la façade (1) du boîtier, et en ce que le volet de fermeture (9), au nombre d'au moins un, qui est monté sur le couvercle de fermeture (2) peut se déplacer vers le bas.

7. Régulateur selon la revendication 5 ou 6, caractérisé en ce que le volet (10), au nombre d'au moins un, qui recouvre la façade (1) peut être monté pour se déplacer vers le bas.

8. Régulateur selon l'une des revendications 1 à 7, caractérisé en ce que, en position ouverte, le couvercle de fermeture (2) se trouve en position inclinée en direction du boîtier (5) par rapport au plan de la façade (1).
